(19) **Europäisches Patentamt**

**European Patent Office**

**Office européen des brevets**

(11) **EP 1 239 455 A2**

(12) **EUROPÄISCHE PATENTANMELDUNG**

(43) Veröffentlichungstag:
**11.09.2002 Patentblatt 2002/37**

(51) Int Cl.⁷: **G10L 11/00**, G06F 17/14,
G01R 23/16

(21) Anmeldenummer: **02360079.4**

(22) Anmeldetag: **07.03.2002**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **09.03.2001 DE 10111249**

(71) Anmelder: **ALCATEL**
**75008 Paris (FR)**

(72) Erfinder: **Walker, Michael**
**73666 Baltmannsweiler 2 (DE)**

(74) Vertreter: **Rausch, Gabriele, Dr. et al**
**Alcatel**
**Intellectual Property Department, Stuttgart**
**70430 Stuttgart (DE)**

(54) **Verfahren und Anordnung zur Durchführung einer an die Übertragungsfunktion menschilcher Sinnesorgane angepassten Fourier Transformation sowie darauf basierende Vorrichtungen zur Geräuschreduktion und Spracherkennung**

(57) Im Bereich der Telekommunikation wird die Fourier Transformation, oftmals die Variante Fast Fourier Transformation, kurz FFT, beispielsweise in Verfahren zur Echounterdrückung, zur Geräuschreduktion, zur Verbesserung der Spracherkennung und zur Kodierung von Audio- und Videosignalen eingesetzt. Bei der FFT sind die Anzahl der Frequenzen N und die Anzahl der Abtastwerte K gleich, der Frequenzabstand ist konstant, die Bandbreite ist konstant, Verzögerung zwischen dem Zeitsignal und dem Frequenzspektrum ist fest. Diese Eigenschaften erlauben keine Anpassung beispielsweise an psychoakustische Merkmale, so ist die Frequenzauflösung des menschlichen Ohres nichtlinear. Erfindungsgemäß wird eine Continuierliche Fourier Transformation, kurz CFT, angegeben, mit der die Zeitfunktion x(k) in Frequenzgruppen abgebildet wird, deren Anzahl und Größe von der Übertragungsfunktion eines zu analysierenden Systems bestimmt wird. Die Summenbildung gemäß der FFT wird bei der CFT durch einen Integrator ersetzt, wodurch staff der bisherigen Blockverarbeitung eine gleitende Fourier Transformation ermöglicht wird.

Fig. 9

## Beschreibung

Die Erfindung betrifft ein Verfahren und eine Anordnung zur Durchführung einer Fourier Transformation, die in der Signalverarbeitung häufig unumgänglich ist, um die Bildfunktion eines Zeitsignals, die Frequenzfunktion, zu analysieren und zu bearbeiten sowie deren Anwendung, insbesondere zur Geräuschreduktion/-unterdrückung und Spracherkennung. Im Bereich der Telekommunikation wird die Fourier Transformation in der Audio- und Video-Übertragung beispielsweise in Verfahren zur Echounterdrückung, zur Geräuschreduktion und Geräuschunterdrückung, zur Verbesserung der Spracherkennung und zur Kodierung von Audio- und Videosignalen eingesetzt. Die Durchführung der mathematisch vollständig beschriebenen Fourier Transformation ist mit technischen Mitteln nur bedingt möglich. So stehen bei der Signalverarbeitung nur zeitdiskrete Abtastwerte zur Verfügung. Die Fourier Transformation kann mit unterschiedlicher Anzahl von Abtastwerten und Bildpunkten durchgeführt werden, woraus sich folgende Probleme ergeben: Welches ist die optimale Zeitauflösung? Wie hoch muss die Auflösung im Bildbereich, im Frequenzbereich, sein und wie ist die günstigste Verteilung der Bildpunkte?

Bei einer sehr großen Anzahl von Bildpunkten werden gegebenenfalls mehr Informationen verarbeitet als notwendig oder von den menschlichen Sinnesorganen wahrnehmbar sind. Die allgemein bekannte blockweise Verarbeitung herkömmlicher Transformationsverfahren führt bei einer großen Anzahl von Bildpunkten zu einer großen Verzögerungszeit. Da die Bandbreiten zwischen den Bildpunkten über dem gesamten Frequenzbereich gleich sind, werden die Reaktionszeiten für große Frequenzen unnötigerweise verlangsamt. Bei einer kleinen Anzahl von Bildpunkten ist die Reaktionszeit gegebenenfalls größer als wahrnehmbar, allerdings kann dann die Auflösung zu gering sein, so dass wichtige Informationen verloren gehen.

Es ist allgemein bekannt, bei der Signalverarbeitung in vielen Produkten die Fast Fourier Transformation, im folgenden FFT genannt, einzusetzen, die im Vergleich zur bekannten Diskreten Fourier Transformation, im folgenden DFT genannt, den Vorteil hat, dass der Rechenaufwand von $N*K$ Rechenoperationen auf $N*ld$ K Rechenoperationen reduziert wird. Bei der FFT werden N diskrete Frequenzen aus K diskreten Abtastwerten nach GI. 1 berechnet.

$$X(n) = \frac{1}{K} \sum_{k=0}^{K-1} x(k) * e^{\frac{-j2\pi nk}{K}} \qquad (1)$$

K     Anzahl der Abtastwerte (Zeitbereich)
k     $0 \leq k < K$
N     Anzahl der Frequenzen (Frequenzbereich)
n     $0 \leq n < N$

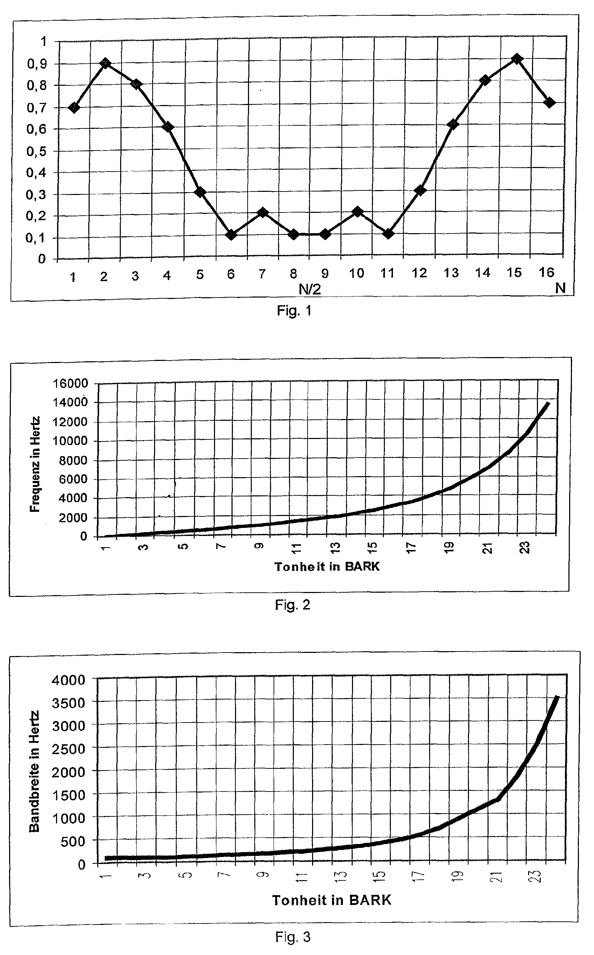

Fig. 1 zeigt ein Ergebnis einer FFT. Auf Grund der Rechenmethode, mit der die FFT durchgeführt wird, wird der Frequenzbereich $0 < n < \frac{n}{2}$ an der Frequenz $\frac{n}{2}$ gespiegelt, so dass der Frequenzbereich $n > \frac{n}{2}$ für die Signalanalyse unberücksichtigt bleiben kann.

Sowohl die DFT als auch die FFT hat folgende Eigenschaften:

- Die Anzahl der Frequenzen N und die Anzahl der Abtastwerte K müssen gleich sein,
- Konstanter Frequenzabstand,
- Konstante Bandbreite,
- Feste Verzögerung zwischen dem Zeitsignal und dem Frequenzspektrum,
- Für die Rücktransformation aus dem Frequenzbereich in den Zeitbereich mittels der Inversen Fast Fourier Transformation (IFFT) sind Fensterung und Overlap-add-Funktion notwendig.

Somit werden bei der FFT wesentliche psychoakustische Merkmale nicht berücksichtigt. Die Frequenzauflösung des menschlichen Ohres ist nichtlinear, wie in späteren Ausführungen noch erläutert wird, die FFT hingegen hat lineare Frequenzauflösung mit äquidistanten Frequenzabständen. Die Zeitauflösung des menschlichen Ohres beträgt etwa 1,9 ms, beispielsweise die einer 256 Punkte FFT jedoch 32 ms. Diese Unterschiede der FFT zu den psychoakustischen Anforderungen lassen eine natürlich wirkende Sprachübertragung nur mit Qualitätseinschränkungen zu.

Allgemein bekannt sind Filterbanklösungen, mit denen eine gehörrichtige Transformation durchgeführt werden kann. So werden hier für 24 Frequenzgruppen FIR -Filter mit 300 Koeffizienten/Frequenzgruppe für eine BARK-Transformation benötigt.
Der Rechenaufwand ist hierbei sehr groß, beispielsweise werden bei einer Abtastrate von 8 kHz 60 Mega Operations per Second (MOPS) benötigt und die Verzögerung des Zeitsignals bezüglich des Frequenzsignals beträgt 18,75 ms.

Mit einer Kaskadenanordnung von Teilbandfiltern, vgl. Kapust, R: Qualitätsbeurteilung codierter Audiosignale mittels einer BARK-Transformation, Dissertation, Technische Fakultät der Universität Erlangen-Nürnberg, 1993, Seite 41, wird zwar eine nichtlineare Frequenzumsetzung erreicht, die einzelnen Frequenzgruppen sind jedoch an ein festes Teilungsverhältnis gebunden, und eine gehörrichtige Transformation wird nicht erreicht.

Bei einem weiteren Lösungsansatz wird von der Fensterlänge einer FFT ausgegangen und die einzelnen zurückliegenden Abtastwerte mit einer Exponentialfunktion gewichtet, vgl. E. Terhardt: Fourier Transformation of Time Signals: Conceptual Revision, Acustica Vol. 57( 1985), Seiten 242-256. Die für die Exponentialfunktion dimensionierten Koeffizienten sind auf eine relativ große Zeitkonstante ausgelegt. Bei der Realisierung dieser Lösung zeigt sich ein kritisches Einschwingverhalten.

Schließlich ist es bekannt, für die Fourier-Transformation den Goerzel-Algorithmus zu verwenden, vgl. R. Kapust: a.a.O., Seiten 58-71. Um die geforderten unterschiedlichen Bandbreiten der BARK-Skala zu erreichen, wird die Polyphasenaddition auf die Eingangssignalblöcke mit unterschiedlichen, aber festem Teilungsverhältnis an die Gesamtblocklänge des zu transformierenden Signals verwendet. Dazu ist jedoch ein sehr großer Rechenaufwand nötig und für die Rücktransformation ist eine Fensterung und eine Overlap-add-Funktion notwendig.

Aus dem bekannten Stand der Technik resultiert die Aufgabe, ein Verfahren, eine Anordnung und darauf basierende Vorrichtungen zur Geräuschreduktion und Spracherkennung anzugeben, mit denen die lineare Auflösung bekannter Transformationsmethoden durch eine weitgehend frei definierbare nichtlineare Auflösung ersetzt wird und somit insbesondere eine Anpassung an die Übertragungsfunktion menschlicher Sinnesorgane ermöglicht wird.

Diese Aufgabe wird durch das im ersten und dritten Anspruch angegebene Verfahren, durch die im 16. und 17. Anspruch angegebenen Anordnungen und die Vorrichtungen gemäß Anspruch 18 und 19 erfüllt.

Das Wesen der Erfindung besteht darin, dass ein Zeitsignal bei der Transformation aus dem Zeitbereich in den Frequenzbereich auf eine vorgegebene, im wesentlichen frei wählbare, Verteilung von Frequenzlinien mit wesentlich verringertem Rechenaufwand abgebildet wird.

Dadurch können insbesondere die nichtlinearen Übertragungsfunktionen des menschlichen Ohres und die nichtlinearen Übertragungsfunktionen des menschlichen Auges bei der Signalverarbeitung von Audio- und Videosignalen bei der Transformation der Signale aus dem Zeitbereich in den Frequenzbereich und umgekehrt mit vertretbaren Rechenaufwand berücksichtigt werden.

Um das Wesen der Erfindung besser darstellen zu können, werden am Beispiel einer akustischen Übertragung die Anforderungen an eine gehöradäquate Transformation erläutert. Die Erfindung ist jedoch nicht auf die akustische Übertragung beschränkt, sondern ist vielmehr in allen den Fällen anwendbar, in denen ein nichtlineares Übertragungsverhalten eines Systems durch eine Fourier Transformation/Rücktransformation bearbeitet werden muss.

So ist eine Reihe von Höreigenschaften bei der Signalverarbeitung unbedingt zu berücksichtigen, wenn ein Audiosignal natürlich klingend empfangen werden soll.

    Frequenzauflösung,

    Zeitauflösung und

    Selektionseigenschaften

des menschlichen Ohres sind bei der Signalübertagung und beispielsweise bei Codiervorgängen, bei Komprimierungsverfahren, beispielsweise nachdem MPEG 3-Standard, und bei der Spracherkennung zu berücksichtigen. Da das Ohr als Nachrichtenempfänger in der Kette der Übertragungsmedien die Schlüsselrolle spielt, müssen Signalverarbeitungsalgorithmen auf diese Gehöreigenschaften abgestimmt sein. Mit der erfindungsgemäßen Lösung wird eine im Vergleich zum Stand der Technik wesentlich verbesserte Nachbildung der Transformationseigenschaften des menschlichen Ohres ermöglicht.

Im menschlichen Ohr findet eine Frequenz-Ortstransformation statt. Durch die Anatomie des Ohres ergibt sich eine nichtlineare Frequenzauflösung. Diese Auflösung ist direkt von der aufgerollten Schnecke, lat. Cochlea, des Innenohres herleitbar. Anregungen innerhalb eines engen Gebietes auf der Cochlea führen zu hörbaren Verdeckungseffekten. Der betroffene Bereich, der diese Verdeckung erfährt, wird als Frequenzgruppe bezeichnet. Gemäß Fig. 2 besitzt das menschliche Ohr 24 Frequenzgruppen, die in einer BARK-Skala (BARK nach Heinrich Barkhausen benannt) dargestellt werden. Die Fig. 2 zeigt die Frequenzempfindung des menschlichen Ohres, nämlich die Tonheit unterteilt in 24 Frequenzgruppen in Abhängigkeit von der Frequenz. Deutlich erkennbar ist der flache Verlauf im unteren Frequenzbereich. Damit ist für tiefe Frequenzen eine größere Frequenzauflösung möglich. Fig. 3 zeigt, dass die Bandbreite der einzelnen Frequenzgruppen mit der Frequenz zunimmt.

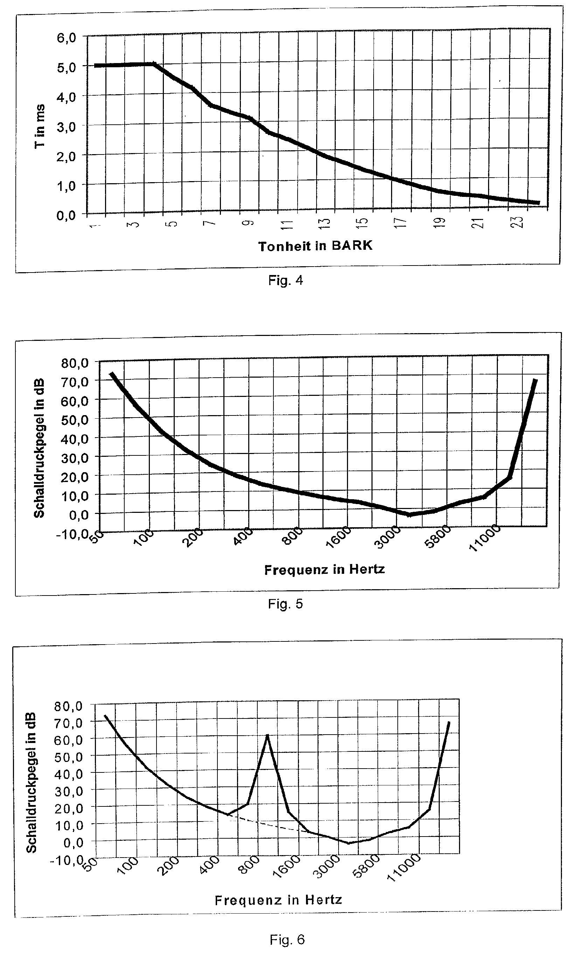

Aus Fig. 4 geht hervor, dass die Zeitauflösung T des menschlichen Ohres mit zunehmender Bandbreite B empfindlicher wird. Sie bewegt sich nahe der Heisenberg-Grenze, die die Reziprozität von Bandbreite B und Zeitauflösung T mit $B * T = 0,5$ beschreibt, somit $T = \frac{0,5}{B}$. Der Mittelwert liegt bei $T \approx 1,9 ms$, vgl. Kapust: a.a.O., Seite 52.

Fig. 5 zeigt den Verlauf der Absoluthörschwelle des menschlichen Ohres in Abhängigkeit von der Frequenz. Entsprechend dieser Funktion kann eine frequenzabhängige Auflösung des Signalpegels gewichtet werden. Im Bereich zwischen 2000 Hz und 6000 Hz ist die Absoluthörschwelle am niedrigsten, eine Tatsache, die bei der Geräuschreduktion besonders berücksichtigt werden muss.

In Fig. 6 sind die Selektionseigenschaften des menschlichen Ohres dargestellt. Schallereignisse innerhalb einer Frequenzgruppe führen zu Verdeckungseffekten. So verdeckt ein Schmalbandrauschen, hier beispielsweise im Bereich $f \approx 1000Hz$, alle kleineren Signalpegel innerhalb der Frequenzgruppe, die von dem Rauschsignal spektral abgedeckt wird. Die Absoluthörschwelle wird somit von einem Maskierer beeinflusst. Die Steigung der Mithörschwelle beträgt im unteren Bereich etwa 100dB/Oktave und nimmt mit zunehmender Frequenz ab.

Im folgenden werden nunmehr das erfindungsgemäße Verfahren näher beschrieben.

Die Bedingung Anzahl N der diskreten Frequenzen gleich Anzahl K der diskreten Abtastwerte bei der FFT des Standes der Technik führt zu festen Bandbreiten, woraus zwei wesentliche Nachteile für eine gehörrichtige Transformation resultieren:

- Keine Anpassung an die BARK-Skala, vgl. Fig. 3 und Fig. 4
- Sehr grobe Zeitauflösung, somit große Zeitkonstanten

Falls $N \neq K$ ist, würden die Bandbreiten nicht mehr mit den Frequenzabständen harmonieren, wodurch entweder starke Überlappungen oder Löcher im Frequenzgang auftreten können.

Um diese Nachteile zu beseitigen, könnte eine Fourier Transformation, für die einzelnen Frequenzbereiche ausgeführt werden. Zur Durchführung der Transformation müssen zunächst die Bandbreiten B der einzelnen Frequenzgruppen, vgl. Fig. 3, bestimmt werden, um damit die für die jeweilige Frequenz zu ermittelnde Anzahl von Abtastwerten zu definieren.

$$X(B,n) = \frac{1}{KB} \sum_{k=0}^{KB} x(k) * e^{\frac{-j2\pi nk}{KB}} \tag{2}$$

X(B,n)    Block / Frequenzbereich mit bestimmter Bandbreite B

KB         Anzahl der Abtastwerte K (Zeitbereich) entsprechend der Bandbreite B

$k \in KB$

N

$n \in N$    Anzahl der Frequenzen (Frequenzbereich), frei wählbar

Gemäß Gl. 2 muss für jede zu berechnende Bandbreite B eine extra Summe gebildet werden. Gemäß Fig. 3 ergeben sich aus der BARK-Skala etwa 11 unterschiedliche Bandbreiten, wobei berücksichtigt ist, dass die Bandbreite im unteren Frequenzbereich bis 12 BARK nahezu konstant ist. Bei einer logarithmischen Skalierung der Frequenzskala hat jede Frequenzlinie eine andere Bandbreite. Da die Summen gemäß Gl. 2 als Blöcke berechnet werden mit einer festen von der Bandbreite abhängigen Größe, wären nunmehr N Blockverarbeitungen notwendig, um die gewünschte Transformation zu erreichen.

Das erfindungsgemäße Verfahren bzw. die erfindungsgemäße Transformation, die nachfolgend auch als Continous Fourier Transformation bezeichnet wird, vermeidet die obigen Nachteile der Blcokverarbeitung. Eine Loslösung von der Blockverarbeitung ist dann möglich, wenn die Summenbildung von einem Integrator durchgeführt wird. Die erfindungsgemäße CFT ersetzt die herkömmliche Blockverarbeitung somit durch eine gleitende Transformation. Als Integrator sind Tiefpassfilter, vorzugsweise rekursive Tiefpassfilter LP, geeignet, siehe Gl. 3.

$$X(n) = LP(n)\left(x(k) * e^{-j2\pi nk/K}\right) \tag{3}$$

X (n)                    Frequenzlinie

Der Integrator muss so dimensioniert werden, dass die zu berechnende Frequenzlinie X(n) im wesentlichen gemittelt wird. Somit ist die Zeitkonstante frequenzabhängig und sollte ein Vielfaches $\nu$ der sich aus der zu berechnenden Frequenz ergebenden Zeitkonstante betragen.

$$\tau \approx \nu \cdot \frac{1}{2 \cdot \pi \cdot n}$$

Durch den Integrator wird auch die Bandbreite B(n) bestimmt, mit der eine Frequenzlinie oder eine Frequenzgruppe übertragen wird. Die Bandbreite B(n) des Integrators, der einer Frequenzlinie X(n) zugeordnet ist, wird aus dem Frequenzabstand der Nachbarfrequenzen von n, also den Frequenzabstand der Frequenzen der linksseitig benachbarten Frequenzlinie X(n-1) und der rechtseitig benachbarten Frequenzlinie X(n+1) bestimmt. Da immer $X(n) < B(n)$ gilt, lassen sich beide Forderungen erfüllen, wenn die Grenzfrequenz des Tiefpassfilters LP nach Gl. 4 bestimmt wird.

$$fg = \frac{B(n)}{2} = \frac{Frequenz(X(n+1)) - Frequenz(X(n-1))}{4} \qquad (4)$$

Der Grad des rekursiven Tiefpassfilters LP ist frei wählbar. Versuche haben gezeigt, dass eine exakte Reproduktion des Zeitsignals mittels CFT und inverser kontinuierlicher Fourier Transformation ICFT bereits mit Tiefpassfiltern 1. Ordnung erreicht werden kann.

Nachfolgend wird eine beispielhafte die Verwendung eines rekursiven Tiefpassfilters 1. Ordnung beschrieben. Der Tiefpassfilter 1'ster Ordnung LP(n) ist für die Bestimmung einer Frequenzlinie X(n) mit der Frequenz (n) vorgesehen. Somit wird die Grenzfrequenz des rekursiven Tiefpassfilters LP(n) gemäß Gleichung 4 gewählt. Die Übertragungsfunktion H(z) des Tiefpassfilters LP(n) lässt sich allgemein einer z-Transformation als

$$H(z) = \frac{a}{1 - b \cdot z^{-1}} \qquad (5)$$

darstellen.

Die rekursive Formel des rekursiven Tiefpassfilters 1. Ordnung ist allgemein:

$$Y(k) = a \cdot y(k) + b \cdot Y(k-1) \qquad (6)$$

Mit

$$b = e^{-\left(\frac{2 \cdot \pi \cdot fg}{Fs}\right)} = e^{-\left(\frac{1}{Fs \cdot \tau}\right)} \quad \text{und} \quad a = 1 - b \qquad (7)$$

wobei Fs die Abtastfrequenz und fg die Grenzfrequenz des Tiefpassfilters sind.

Mit allgemeine Transformationsgleichung (3) und Gleichung (6) lässt sich die Transformation für eine Frequenzlinie X(n) dann umschreiben in

$$X(n,k) = a(n) \cdot \left(x(k) \cdot e^{-j2\pi nk/K}\right) + b(n) \cdot X(n,k-1) \qquad (8)$$

$$X(n,k) = a(n) \cdot \left(x(k) \cdot \cos(2\pi/K \cdot nk) - j \cdot x(k) \cdot \sin(2\pi/K \cdot nk)\right) + b(n) \cdot X(n,k-1) \qquad (8a)$$

$$X(n,k) = a(n) \cdot \left(x(k) \cdot \cos(cnk) - j \cdot x(k) \cdot \sin(cnk)\right) + b(n) \cdot X(n,k-1) \,; c = 2\pi/K \qquad (8b)$$

X(n,k) beschreibt dabei die Frequenzlinie an der diskreten Frequenz n zum (Abtast-) Zeitpunkt k. Gemäß Gl. 8a kann die komplexe Funktion $e^{-j2\pi nk/K}$ durch die bekannte aus Cosinus- und Sinusfunktion-Darstellung ersetzt werden kann. Durch die Verwendung jeweils eines rekursiven Filters für den Realteil und den Imaginärteil kann der Realteil Re(X(n,k)) und Imaginärteil Im(X(n,k)) der Frequenzlinie X(n,k) getrennt ermittelt werden:

$$X(n,k) = a(n) \cdot x(k) \cdot \cos(cnk) + b(n)\,\mathrm{Re}(X(n,k-1)$$
$$- j \cdot (a(n) \cdot x(k) \cdot \sin(cnk) + b(n) \cdot \mathrm{Im}(X(n,k-1))) \; ; c = 2\pi / K \qquad (8c)$$

Die Betragsbildung |X(n,k)| kann dann wie üblich durch Quadrierung jeweils des Realteils und Imaginärteils und anschließendes Bilden der Quadratwurzel der Summe dieser Teile erfolgen:

$$|X(n,k)| = \sqrt{((\mathrm{Re}(X(n,k))^2 + (\mathrm{Im}(X(n,k))^2)} \qquad (8d)$$

Somit kann eine quasi kontinuierliche Transformation des Zeitsignals durchgeführt werden. Die Nachteile der blockweisen Berechung bzw. Summenbildung des Standes der Technik , z.B. bei der FFT, werden vermieden.

Eine sehr gute Approximation an den Verlauf der Absoluthörschwelle des menschlichen Ohres gemäß Fig. 5 ist mit rekursiven Filtern 8. Ordnung erreichbar.

Die Rücktransformation kann nach Gl. 9 erfolgen:

$$x(k) = \sum_{n=0}^{N-1} X(n) \cdot e^{j2\pi nk/K} \qquad (9)$$

Die komplexen Frequenzen für die CFT und ICFT können entweder wie üblich aus einer Tabelle entnommen werden oder mittels Sinustongenerator frei erzeugt werden. Hierbei muss dann eine exakte Phasenbeziehung zwischen Sinus- und Cosinusschwingung eingehalten werden. Versuche mit freien Oszillatoren haben gezeigt, dass mit jeder beliebigen Frequenz gerechnet werden kann.

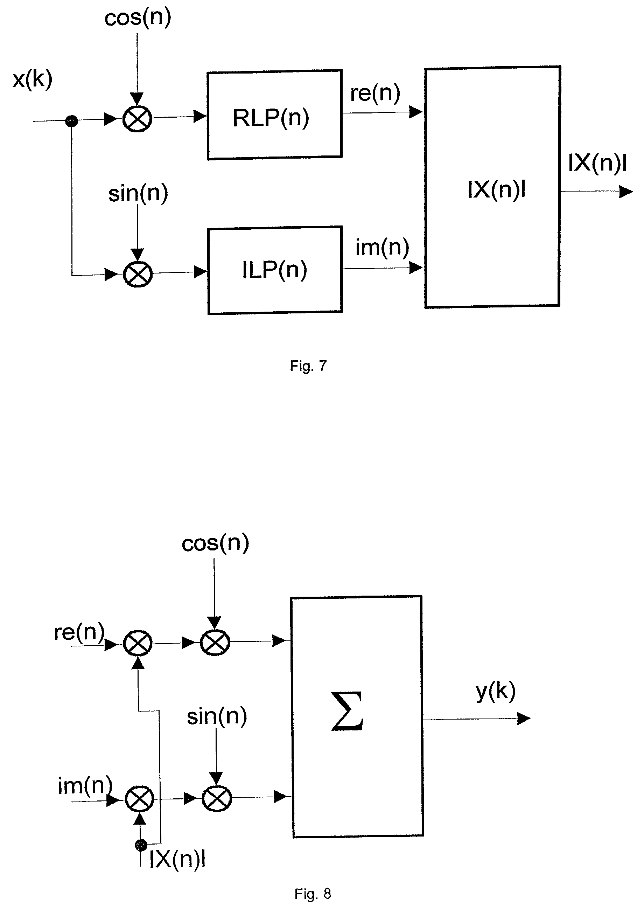

Eine Schaltungsanordnung zur Durchführung des Verfahrens ist in Fig. 7 und Fig. 8 dargestellt. Für die CFT gemäß Fig. 7 wird ein diskreter Abtastwert x(k) im Zeitbereich mit dem Sinus-Abtastwert sin(cnk) und dem Cosinus-Abtastwert cos(cnk) der betreffenden Frequenzlinie n im zugehörigen ersten Tiefpassfilter ILP(n) als Imaginärteil und im zweiten Tiefpassfilter RLP(n) als Realteil gefaltet. Die Betragsbildung aus der gefalteten Funktion re(n) am Ausgang des zweiten Tiefpassfilters RLP(n) und der gefalteten Funktion im(n) am Ausgang des ersten Tiefpassfilters ILP(n) erfolgt gemäß Gl. 11 und wird beispielsweise mit einem Kurzzeitmittelwertbildner SAM, short average magnitude, realisiert.

$$|X(n)| = f\!\left(\sqrt{re^2(n) + im^2(n)}\right) \qquad (11)$$

Bei der ICFT gemäß Fig. 8 werden für alle n mit $0 \le n < N$ der Realteil re(n) und der Imaginärteil im(n) der Frequenzfunktion F(n)= re(n)- j·im(n) der Filterkurve mit dem jeweiligen Betragswert |X(n)| der in den Frequenzbereich transformierten Eingangsfunktion x(k) gewichtet und anschließend mit dem Cosinusabtastwert cos(cnk) bzw. dem Sinusabtastwert sin(cnk) multipliziert. Beide Ergebnisse werden nach Gl. 12 summiert und ergeben das rücktransformierte Signal y(k).

$$y(k) = \sum_{n=0}^{N-1} (|X(n)|re(n)\cos(cnk) + |X(n)|im(n)si(cnk)), c = 2\pi / N \qquad (12)$$

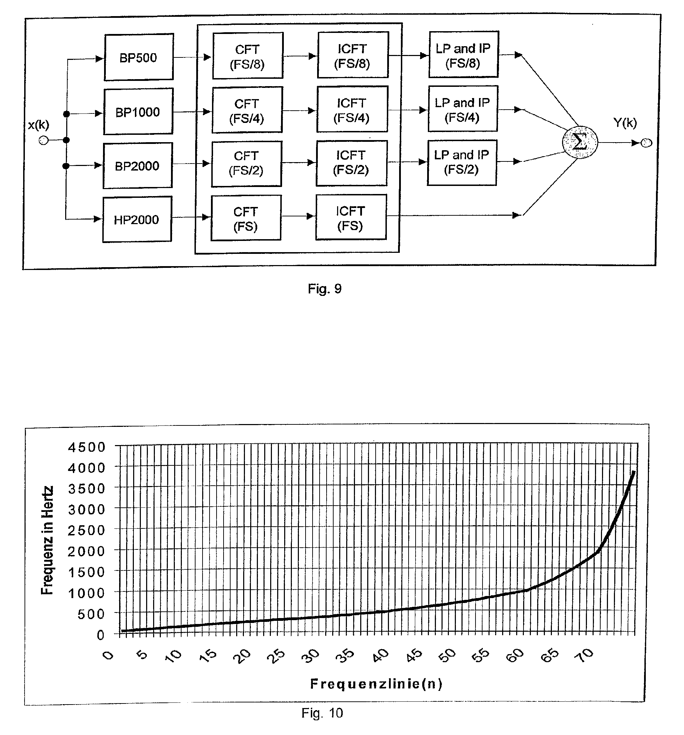

Fig. 9 zeigt ein Ausführungsbeispiel bei dem die Hintransformation CFT eines Zeitsignals x(k) in ein Frequenzsignal X(n) und die Rücktransformation ICFT eines Frequenzsignals X(n) in ein Zeitsignal y(k) dargestellt ist. Das Eingangssignal x(k) ist logarithmisch skaliert in vier Frequenzgruppen aufgeteilt. Bei einer Abtastfrequenz $Fs = 8KHz$ wird eine erste Frequenzgruppe mit einer Bandbreite $B = 500Hz$ bei einer Abtastfrequenz $\frac{1}{8}Fs = 1000Hz$, eine zweite Frequenzgruppe mit einer Bandbreite $B = 1000Hz$ bei einer Abtastfrequenz $\frac{1}{4}Fs = 2000Hz$, eine dritte Fre-

quenzgruppe mit einer Bandbreite $B = 2000Hz$ bei einer Abtastfrequenz $\frac{1}{2}Fs = 4000Hz$ und eine vierte Frequenzgruppe für Frequenzen bis 4000 Hz bei einer Abtastfrequenz $Fs = 8000Hz$ gebildet. Über die Bandpässe BP 500, BP 1000 und BP 2000 sowie über den Hochpass HP 2000 wird das Eingangssignal x(k) gemäß Fig. 9 mittels CFT in den Frequenzbereich transformiert, dort je nach Anwendungsfall verarbeitet und mittels der ICFT wieder in den Zeitbereich über Tiefpassfilter LP und Interpolationsfilter IP und Summenbildung zurücktransformiert.

Der Rechenaufwand für die CFT gemäß Fig. 7 beträgt für eine Frequenzlinie insgesamt 17 Rechenoperationen, nämlich bei einer Filterung erster Ordnung jeweils 1 Rechenoperation für die Faltung und 3 Rechenoperationen für die Filterung, so dass für die Bildung der komplexen Größen 8 Rechenoperationen erforderlich sind. Hinzu kommen 7 Rechenoperationen für die Bildung des gemittelten Betrages $|X(n)|$ und 2

Rechenoperationen für eine Statusabfrage über Anstieg und Abfall der gemittelten Werte. Für die ICFT sind 5 Rechenoperationen notwendig, nämlich jeweils eine für die Faltung , eine für die Gewichtung mit dem Betrag und eine für die Summenbildung.

Es sind somit 22 Rechenoperationen für die Berechnung einer Frequenzlinie erforderlich. Der gesamte Rechenaufwand CP beträgt damit bei einer CFT mit wie in Fig. 10 dargestellten 75 Frequenzlinien und einer Abtastfrequenz $Fs = 8kHz$

$$CP = 22 * 75 * 8000 = 13,2 MOPS$$
$$= 13,2 \text{ Mega Operations per second}$$

Fig. 10 zeigt die Verteilung der Frequenzlinien auf die Frequenzgruppen, wie sie beispielsweise bei einer wirtschaftlich optimierten Version besonders vorteilhaft ist. Diese Aufteilung eignet sich auch hervorragend bei der Anwendung einer Geräuschreduktion im Spektralbereich.

Auf die erste Frequenzgruppe bis 500 Hz entfallen 40 Frequenzlinien, auf die zweite Frequenzgruppe bis 1000 Hz entfallen 20 Frequenzlinien, auf die dritte Frequenzgruppe bis 2000 Hz entfallen 10 Frequenzlinien und auf die vierte Frequenzgruppe bis 4000 Hz entfallen 5 Frequenzlinien. Eine hohe Frequenzauflösung ist in dem dargestellten Beispiel der Geräuschreduktion gerade in dem Frequenzbereich gewünscht, in dem die meisten von dem Störer herrührenden Frequenzen auftreten, das ist praktisch der Bereich zwischen f=0 ... 2kHz. Wie in Fig. 10 dargestellt, wurden 75 Frequenzlinien logarithmisch so verteilt, dass die Frequenzauflösung im unteren Frequenzbereich bis 500 Hz besonders groß ist, sie beträgt hier 10 Hz. Eine solche Frequenzauflösung wird nicht einmal mit einer FFT mit 512 Frequenzlinien erreicht, hier ist die Frequenzauflösung 16 Hz. Gemäß Fig. 10 nimmt die Frequenzauflösung bis zur obersten Frequenzlinie auf 510 Hz ab, das entspricht einer Zeitauflösung von 0,98 ms, wohingegen die FFT mit 512 Frequenzlinien einen konstanten Wert von 31,25 ms aufweist. Mit der CFT wird somit problemlos erreicht, dass die bei der FFT auftretenden Musical Tones nicht auftreten.

Der oben genannte Rechenaufwand lässt sich durch Unterabtastung mit Dezimierungsfiltern und Interpolationsfiltern stark reduzieren. Der Bereich mit den meisten Frequenzlinien lässt sich am stärksten unterabtasten. Versuche haben gezeigt, dass sich die o.g. 75 Frequenzlinien pro Abtastwert auf 20 Frequenzlinien pro Abtastwert ohne Qualitätsverlust reduzieren lassen. Für die Filterung wurden im Versuch elliptische kanonische Filter 8. Ordnung gewählt. Der Aufwand beträgt 70 Rechenoperationen für alle Filter, womit der Rechenaufwand bei diesem Beispiel

$$CP(75) = (22 * 20 + 70) * 8000$$
$$= 4,08 \text{ MOPS } \text{ beträgt.}$$

Bei dieser Abschätzung wurden keine DSP-spezifischen Multiplikationen mit Additionen (MAC) verwendet. Somit kann hier hardwaremäßig nochmals eingespart werden.

Der Vorteil einer logarithmischen Frequenzaufteilung oder einer Frequenzaufteilung in Frequenzgruppen in BARK besteht darin, dass gerade bei den stark unterabgetasteten Frequenzen relativ mehr Frequenzlinien berechnet werden und somit in der Summe wesentlich weniger Frequenzlinien pro Abtastwert berechnet werden müssen. Hier bietet die CFT alle Freiheitsgrade je nach Anwendung.

Außer der gehörrichtigen Transformation bei Berücksichtigung der BARK-Skala ist insbesondere bei Einsatz der CFT in Kombination mit einem Codec die gehörrichtige Verteilung der Frequenzlinien nach der mel-Skala von praktischer Bedeutung. Die Verhältnistonhöhe $H_v$ als Funktion der Frequenz f wird in mel (abgeleitet von Melodie) gemessen, vgl. E. Zwicker: Psychoakustik, Springer Verlang, Berlin Heidelberg New York, 1982, Seiten 57 - 60. Versuche mit der CFT/ICFT haben gezeigt, dass bereits mit 17 Frequenzlinien bei 8 kHz Abtastrate eine gehörrichtige Reproduktion des Zeitsignals unter Ausnutzung der Maskierung des Gehörs erreicht wird.

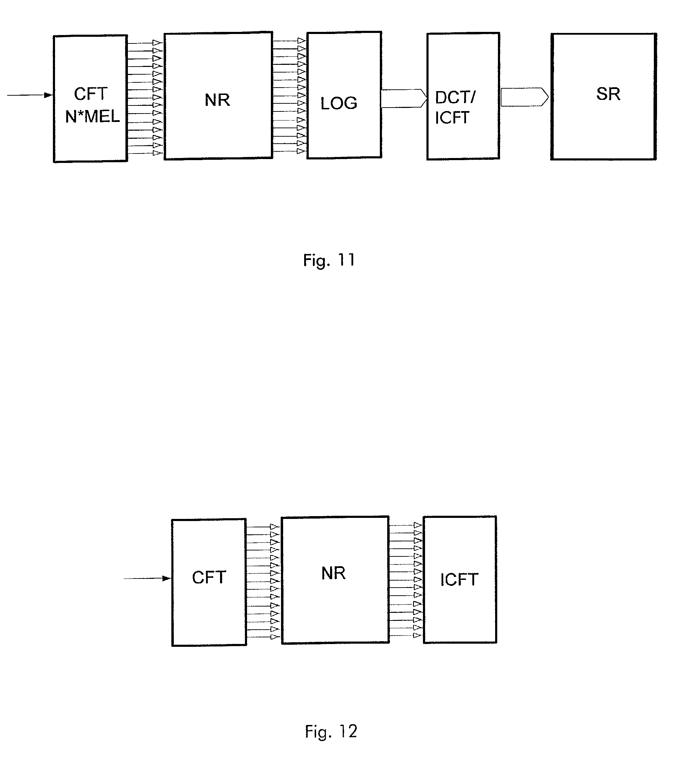

Besonders vorteilhaft ist der Einsatz der CFTbei Spracherkennungseinrichtungen. Ein beispielhaftes Blockschaltbild für eine Spracherkennungsvorrichtung ist in Fig. 11 gezeigt. Während bei der FFT eine Nachbearbeitung der linear verteilten Frequenzlinien zur Aufbereitung der Sprachkoeffizienten erforderlich ist, entfällt bei der CFT diese Nachbearbeitung, da bei der CFT eine für die Spracherkennungsvorrichtung vorteilhafte Verteilung der Frequenzlinien, beispielsweise nach der mel-Skala, unmittelbar erzeugt werden kann. Der kombinierten CFT-mel-Transformation, die in Figur 11 mit CFT N∗mel bezeichnet ist, ist eine Geräuschreduktionseinheit NR zur Geräuschreduktion eines Sprachsignals im Frequenzbereich nachgeschaltet, die z.B. auf einen Wiener-Filter oder den Ephraim/Malah Algorithmus basiert. In einer Logarithmiereinheit LOG werden Cepstrum-Koeffizienten berechnet. Die mittels DCT (Diskreter Kosinus Transformation) oder ICFT in den Zeitbereich rücktransformierten Signale werden dann einer bekannten Spracherkennungseinheit zur Spracherkennung zugeführt. Die CFT kann auch auf andere dem Fachmann bekannten Spracherkennungsvorrichtungen/-verfahren angewendet werden, auch wenn diese sich von dem beispielhaften Blockschaltbild der Figur 11 unterscheiden, sofern dabei eine Zeit-Frequenz-Transformation eines Sprachsignals zur Spracherkennung verwendet wird.

Als Adaptive Multirate Codecs können die CFT als Coder und die ICFT als Decoder vorteilhafterweise direkt eingesetzt werden. Durch den großen Freiheitsgrad der Dimensionierungsmöglichkeiten lassen sich CFT/ICFT problemlos an unterschiedliche Bitraten anpassen.

Der Einsatz der FFT bei der Geräuschreduktion bei Verwendung eines Wiener-Filters oder bei Anwendung des Algorithmus von Ephraim/Malah, vgl. Y. Ephraim, D. Malah: "Speech enhancement using a minimum meansquare error short-time spectral amplitude estimator", IEEE Trans. Acoust. Speech Signal Processing, vol. ASSP32, Seiten 1109 - 1121, Dec. 1984 führt bekanntermaßen zu störenden sogenannten Musical Tones.

Eine beispielhafte Vorrichtung zur Geräuschunterdrückung mittel CFT ist in Figur 12 dargestellt. Ein Sprachsignal wird mittels der erfindungsgemäßen CFT aus dem Zeitbereich in den Frequenzbereich transformiert. Im Frequenzbereich erfolgt dann die Signalverarbeitung, und zwar in Figur 11 mittels einer Geräuschreduktionseinheit NR, die z.B. auf ein Wiener Filter oder das Verfahren nach Ephraim/Malah verwendet. Nach erfolgter Signalbearbeitung wird das Sprachsignal mittel ICFT rücktransformiert. Durch die Anwendung der nichtlinearen CFT wird die Entstehung der unerwünschten Musical Tones verhindert, da die bei der FFT über eine Blöcklänge erzeugten Fehler überhaupt nicht auftreten können. Eine weitere Qualitätsverbesserung ist dadurch gegeben, daß die Anzahl der Frequenzlinien im Geräuschbereich groß gewählt wird und damit eine hohe Auflösung des Störspektrums erreicht wird.

So lässt sich die CFT vorteilhaft mit Verfahren zur Geräuschreduktion, zur Echounterdrückung, mit Komprimierungsverfahren, beispielsweise nach dem MPEG3-Standard, kombinieren und als Coder und Decoder, beispielsweise gemäß GSM-Standard, einsetzen. Je nach Übertragungsfunktion der zu analysierenden oder nachzubildenden Systeme kann die CFT/ICFT den entsprechenden Erfordernissen hinsichtlich Frequenzauflösung und Zeitauflösung durch Wahl der Frequenzgruppen und Anzahl der Frequenzlinien angepasst werden.

**Patentansprüche**

1. Verfahren zur Durchführung einer insbesondere an die Übertragungsfunktion menschlicher Sinnesorgane angepassten Fourier Transformation, mit der ein Zeitsignal (x(k)) aus dem Zeitbereich in den Frequenzbereich in Form von Frequenzlinien (X(n)) abgebildet wird, mit einer vorgegebenen Anzahl und Verteilung der Frequenzlinien im Frequenzbereich,
**dadurch gekennzeichnet**,

   - das zur Bestimmung des Wertes einer Frequenzlinie (X(n)) der Frequenz (n)

   - das Zeitsignal (x(k)) mit dem Cosinusabtastwert (cos(cnk)) und dem Sinusabtastwert (sin(cnk)) der betreffenden Frequenz (n) multipliziert wird,

   - der derart gebildete Realteil (re(n)) und Imaginärteil (im(n)) jeweils getrennt in Filtern für den Realteil (RLP(n)) und den Imaginärteil (ILP(n)), die an die Frequenz angepasst sind, gefiltert wird

   - und zur Bestimmung des Betragswertes $|X(n)|$ der Frequenzlinie eine Berechnung der Quadratwurzel aus der Summe des jeweils quadrierten gefilterten Realteils (re(n)) und des quadrierten gefilterten Imaginärteil (im(n)) erfolgt.

2. Verfahren nach Anspruch 1, **dadurch gekennzeichnet, dass** die Filter (RLP(n), ILP(n)) derart an die Frequenz angepasst sind, dass die Filter (RLP(n), ILP(n)) eine Grenzfrequenz (fg) aufweisen, die ein viertel des Frequenzabstandes der der Frequenzlinie (X(n)) linkseitig und rechtseitig benachbarten Frequenzlinien (X(n-1), X(n+1)) beträgt.

3. Verfahren zur Durchführung einer der Fourier Transformation nach Anspruch 1 oder 2 zugeordneten Inversen Fourier Transformation, **dadurch gekennzeichnet, dass** zur Berechnung des gefilterten Zeitwerts y(k) die Realteile (re(n)) und die Imaginärteile (im(n)) der Frequenzfunktion des Filters mit den entsprechenden Beträgen der entsprechenden Frequenzlinien (X(n,k)) gewichtet werden und diese gewichteten Ergebnisse jeweils mit den entsprechenden Cosinusabtastwerten (cos(cnk)) bzw. Sinusabtastwerten (sin(cnk)) weiter gewichtet werden und diese zweifach gewichteten Werte über alle Frequenzwerte (N) aufsummiert werden.

4. Verfahren nach Anspruch 1, **dadurch gekennzeichnet, dass** das Zeitsignal (x(k)) im Frequenzbereich in Frequenzgruppen abgebildet wird, deren Anzahl und Größe von der Übertragungsfunktion eines zu analysierenden Systems bestimmt wird, wobei die Frequenzgruppen eine einzelne oder eine Mehrzahl von Frequenzlinien umfassen.

5. Verfahren nach Anspruch 4, **dadurch gekennzeichnet, dass** die Frequenzlinien (X(n)) innerhalb einer Frequenzgruppe derart berechnet werden, dass die Frequenzauflösung und die Zeitauflösung an die Übertragungsfunktion menschlicher Sinnesorgane angepasst ist.

6. Verfahren nach Anspruch 1, **dadurch gekennzeichnet, dass** zwecks Anpassung an das Zeitverhalten des menschlichen Ohres eine Filterung des Betrags ($|X(n)|$) der Frequenzlinie (X(n)) vorgenommen wird.

7. Verfahren nach Anspruch 4, **dadurch gekennzeichnet, dass** die Größe der Frequenzgruppen gemäß der BARK-Skala bestimmt werden.

8. Verfahren nach Anspruch 4, **dadurch gekennzeichnet, dass** die Größe der Frequenzgruppen gemäß einer logarithmischen Skala bestimmt werden.

9. Verfahren nach Anspruch 4, **dadurch gekennzeichnet, dass** die Anzahl der Frequenzlinien von Frequenzgruppe zu Frequenzgruppe logarithmisch skaliert sind.

10. Verfahren nach Anspruch 4, **dadurch gekennzeichnet, dass** die Frequenzlinien innerhalb einer Frequenzgruppe logarithmisch skaliert sind.

11. Verfahren nach Anspruch 4, **dadurch gekennzeichnet, dass** bestimmte Frequenzgruppen gebildet werden, deren jeweils höchste Frequenz die Abtastrate der gebildeten Frequenzgruppe nach dem Abtasttheorem bestimmt.

12. Verfahren nach Anspruch 4, **dadurch gekennzeichnet, dass** zum Zwecke der Spracherkennung die Größe der Frequenzgruppen und die Anzahl der Frequenzlinien an den Verlauf der Funktion mel = g(f) angepasst werden.

13. Verfahren nach Anspruch 4, **dadurch gekennzeichnet, dass** zum Zwecke der Codierung und Decodierung mit einem Codec für eine gehörrichtige Übertragung eine Verteilung der Frequenzgruppen und Frequenzlinien nach der BARK-Skala oder nach der mel-Skala vorgenommen wird.

14. Verfahren nach Anspruch 4, **dadurch gekennzeichnet, dass** die Verteilung der Frequenzlinien und deren Zusammenfassung in Gruppen bei einem Adaptiven Multirate Codec gemäß den Standards bei der GSM-Übertragung an unterschiedliche Bitraten angepasst wird.

15. Verfahren nach Anspruch 4, **dadurch gekennzeichnet, dass** die Verteilung der Frequenzlinien bei dem Einsatz zur Geräuschreduktion, zur Echounterdrückung oder bei Daten-Komprimierungsverfahren jeweils an die Übertragungsfunktion des zu analysierenden und zu bearbeitenden Systems angepasst wird.

16. Anordnung zur Transformation einer Zeitfunktion (x(k)) aus dem Zeitbereich in den Frequenzbereich, **dadurch gekennzeichnet,**
**dass** das Zeitsignal (x(k)) nach einer Faltung mit den Cosinus- und Sinus-Abtastwerten der Frequenzlinie (X(n)) einem Filter für den Realteil (RLP(n)) und einem Filter für den Imaginärteil (ILP(n)) zugeführt wird und die Ausgänge der Filter mit einem Betragsbildner ($|X(n)|$) verbunden sind, aus dessen Ausgang der Betrag einer Frequenzlinie (X(n)) bereitgestellt wird.

**17.** Anordnung zur Transformation einer Frequenzlinie (X(n)) aus dem Frequenzbereich in den Zeitbereich, **dadurch gekennzeichnet, dass** der Realteil (re(n)) und der Imaginärteil (im(n)) des Filterfrequenzwerts nach Wichtung mit dem Betrag der Frequenzlinie (|X(n)|) und Multiplikation mit den entsprechenden Cosinusabtastwerten und Sinusabtastwerten einem Summierer zugeführt werden, an dessen Ausgang gemäß

$$y(k) = \sum_{n=0}^{N-1} |X(n)|(re(n)\cos(2\pi nk / N) + im(n)\sin(2\pi nk / N))$$

die Zeitfunktion (y(k)) bereitgestellt wird.

**18.** Vorrichtung zur Geräuschreduktion, umfassend eine Zeit-Frequenz-Transformationseinheit (CFT) nach Anspruch 16, eine Frequenz-Zeit-Transformationseinheit (ICFT) nach Anspruch 17 und eine Geräuschreduktionseinheit (NR), wobei die Geräuschreduktionseinheit (NR) zwischen Zeit-Frequenz-Transformationseinheit (CFT) und Frequenz-Zeit-Transformationseinheit (ICFT) geschaltet ist und eine Geräuschreduktion am frequenztransformierten Zeitsignals erfolgt.

**19.** Vorrichtung zur Spracherkennung, **dadurch gekennzeichnet, dass** die Vorrichtung eine Zeit-Frequenz-Transformationseinheit (CFT) nach Anspruch 16 umfasst.

Fig. 1

Fig. 2

Fig. 3

Fig. 4

Fig. 5

Fig. 6

Fig. 7

Fig. 8

Fig. 9

Fig. 10

Fig. 11

Fig. 12